Europäisches Patentamt

European Patent Office

Office européen des brevets

(11) Publication number: **0 661 812 A1**

# EUROPEAN PATENT APPLICATION

(21) Application number: 93830544.8

(51) Int. Cl.6: **H03K 19/003**, H03K 19/0185

(22) Date of filing: **31.12.93**

(43) Date of publication of application:
**05.07.95 Bulletin 95/27**

(84) Designated Contracting States:
**DE FR GB IT**

(71) Applicant: **SGS-THOMSON MICROELECTRONICS S.r.l.**

Via C. Olivetti, 2

I-20041 Agrate Brianza (Milano) (IT)

(72) Inventor: **Demicheli, Marco**

Via Dante 18

I-22070 Binago (CO) (IT)

(54) Interface TTL/CMOS circuit with temperature and supply voltage independent threshold level.

(57) A TTL/CMOS interface circuit having a tripping threshold unaffected by variations in temperature and supply voltage, comprises an input stage (Si), and an output stage (Su) which is an inverter.

The input stage comprises a pair of inverters (M2,M3 and M5,M6) powered through a current mirror structure (M1,M4). The first of said inverters (M2,M3 and M5,M6) has an input terminal connected to a voltage reference (VREF) with the same value as the TTL switching threshold, and an output terminal connected to a control terminal (A) of the current mirror structure (M1,M4).

The second inverter (M5,M6) has an input terminal (IN) forming the input terminal of the interface circuit and an output terminal connected to the output stage (Su).

The interface circuit is supplied a voltage equal to the CMOS supply voltage.

This invention relates to interface circuits for coupling together integrated circuit of different types, and in particular concerns an interface circuit for coupling digital logic circuits of the TTL type to processing circuits of the CMOS type.

There are several applications where the levels of logic signals require to be suitably transferred to the higher ones of CMOS processing.

Essential features are, for an interface circuit serving the above function, a capability to operate at high or very high frequencies, low power consumption, and reduced integration area requirements.

The simplest of the circuits that fill these demands consists of a chain of inverters which allow the logic signals of the TTL type to be amplified while maintaining high-speed output signal edges.

A typical solution provides for the use of two inverters which are supplied a voltage at CMOS level of about 5 V and comprise each a pair of complementary field-effect transistors having gate electrodes driven by the same input signal.

The switching threshold of the first inverter should be equal to the tripping threshold of the TTL logic signals, namely 1.4 V.

Thus, copy signals of the input logic signals to the first inverter can be output to the second inverter at levels which are typical of CMOS circuit signals.

A critical factor to the proper operation of inverter-chain interfacing circuits is the first inverter dimensioning, as the latter should have its switching threshold accurately centered to the TTL tripping threshold.

The accuracy of that centering may be significantly lowered, however, by variations in the characteristics of the integration process and variations in temperature and supply voltage while in operation.

Known to the skilled ones in the art are several solutions to that problem, a specially effective one being that of supplying the first inverter with a supply voltage at an intermediate level between the TTL and CMOS levels and connecting, in series between the first and second inverters, a field-effect transistor having a low threshold and its gate electrode driven by that intermediate level voltage.

Such an approach is described in Italian Patent No. 1228175 by this Applicant.

The underlying problem of this invention is to provide an interface circuit for coupling circuits of the TTL type to circuits of the CMOS type, which affords, by simple circuitry and using a power supply of just one kind, operation characteristics which are unaffected by any variations in the parameters of the integration process and variations in temperature and supply voltage.

This problem is solved by an interface circuit as previously indicated and defined in the characterizing parts of the appended claims to this specification.

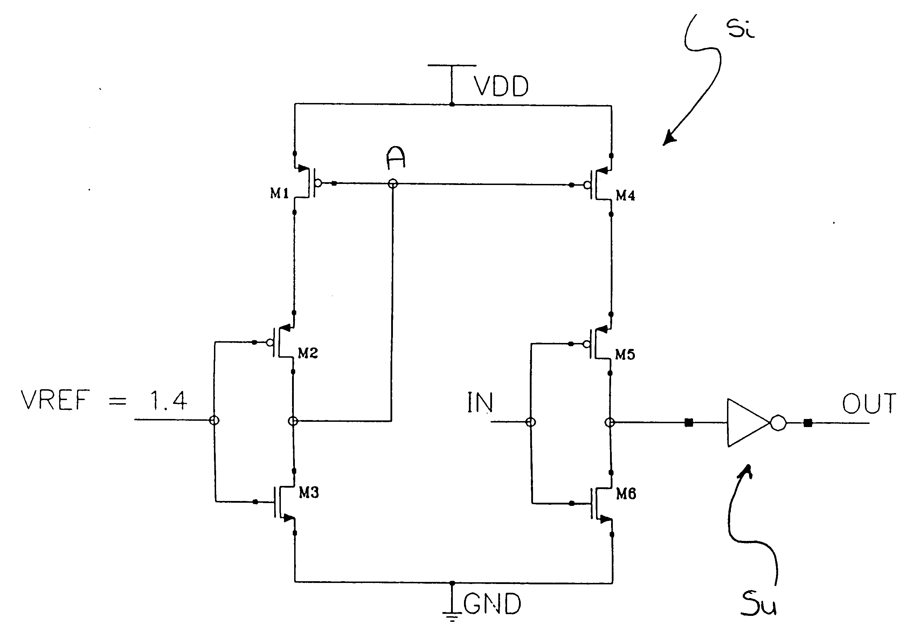

The features and advantages of an interface circuit according to the invention will be apparent from the following description of an embodiment thereof, given by way of example and not of limitation with reference to the accompanying drawing.

In the drawing:
- the only Figure shows a circuit diagram for a preferred embodiment of an interface circuit according to the invention.

An interface circuit according to the invention comprises an input stage and an output stage, as indicated at Si and Su in the drawing.

These stages are of the logic gate circuit type. In accordance with the invention, there are several types of logic gates that may be used, besides inverters or triggers as specified in the preferred embodiment shown in the drawing.

The input stage is connected, like the output stage, between first GND and second VDD terminals of a voltage generator supplying a voltage equal (5 V) to that of the CMOS circuit to be coupled to a TTL circuit, and its structure allows for flexible use of different circuit elements of the logic type.

The input stage comprises, in fact, first and second logic gate circuits connected between the two terminals of the supply voltage generator in series with a circuit structure of the current mirror type.

Shown in the drawing is an embodiment of an interface circuit according to the invention, which can be integrated monolithically by a technology of the CMOS type.

As shown, the first and second logic gate circuits are inverters comprising a pair of complementary transistors M2, M3 and a pair of complementary transistors M5, M6, respectively.

The current mirror structure consists of two transistors, M1 and M4, connected with their source and drain terminals between the inverters and the terminal VDD of the supply voltage generator.

The gate terminals of the transistors M1 and M2 are connected together into a circuit node A which may be regarded as a control terminal of the current mirror structure.

Connected to this node is the output terminal of the first inverter consisting of a node of interconnection of the drain terminals of the transistors M2 and M3.

The gate terminals of said transistors M2 and M3 are connected together to form the input terminal of the first inverter which is connected, in accordance with the invention, to a voltage reference VREF having a value (1.4 V) equal to the voltage value of the tripping threshold at which the TTL circuit to be coupled to the CMOS circuit is operated.

Similarly, the gate and drain terminals of the transistor M5 are respectively connected to the gate and drain terminals of the transistor M6 to form the input terminal and output terminal of the second inverter, which also form the input terminal IN of the interface circuit and output terminal of the input stage Si, respectively.

Connected to this output terminal is the output stage Su whose output terminal forms the output terminal OUT of the interface circuit.

The source terminals of the transistors M3 and M6 are connected to the terminal GND of the supply voltage generator and those of the transistors M2 and M5 are connected to the drain terminals of the transistors M1 and M4 of the (here extremely simple) circuit structure of the current mirror type.

In another embodiment, a trigger type of circuit, i.e. a hysteresis circuit, is substituted for the transistors MS and M6 of the second inverter.

As for the operation of an interface circuit according to the invention, in the embodiment shown the circuit may be regarded as split into a reference portion comprising the transistors M1, M2 and M3 and a conversion portion proper comprising the transistors M4, M5 and M6 and the inverter Su.

When the value of the reference voltage applied to the input terminal of the first inverter is selected as previously specified, i.e. median (1.4 V) to the voltage values of the two TTL logic levels, the drain of the transistor M1 and that of the transistor M2 will be at a potential value close to the tripping threshold of a CMOS inverter regardless of any variations in the process characteristics as well as in temperature and supply voltage.

If the area ratii of the transistors are held the same, i.e. if:

$$M4/M1 = M5/M2 = M6/M3 = K$$

is impressed, then on application, to the gate terminals of the transistors M5 and M6 via the input terminal IN, of a voltage equal to the reference voltage, their drains will also be brought close to the tripping threshold of the output inverter Su.

In view of the voltage gain between the gates and the drains of the transistors M5 and M6, switching at the output between the low logic level and the high logic level can always take place for voltage values close to the reference voltage, regardless of process variations and variations in temperature and supply voltage.

By dimensioning the input stage such that the ratio K of the transistor areas has a high value, low static consumption of power can be attained while retaining a high switching speed.

As relates to the embodiment wherein the transistors M5 and M6 are replaced with a trigger circuit, no disadvantages are to be experienced in terms of consumption and speed, and in addition, the substitution introduces a hysteresis in the input signal, thereby lowering the sensitivity to any noise affecting the signal.

It should be understood that many modifications, adaptations, integrations, and substitutions of elements may be made unto the embodiments described hereinabove without departing from the protection scope of the following claims.

**Claims**

1. An interface circuit for coupling a circuit of the TTL type to a circuit of the CMOS type, comprising an input stage (Si) and an output stage (Su), both being of the logic gate circuit variety and connected between first (VDD) and second (GND) terminals of a generator of a supply voltage having substantially the same value as the supply voltage to the CMOS-type circuit, characterized in that the input stage (Si) comprises first (M2,M3) and second (M5,M6) logic gate circuits, each having at least one input teminal and at least one output terminal, said first and second logic gate circuits being connected between the two terminals of the supply voltage generator in series with a circuit (M1,M4) of the current mirror variety having a control terminal (A) connected to the output teminal of the first logic gate circuit whose input terminal is connected to a voltage reference (VREF) having substantially the same value as the voltage value of the tripping threshold at which the TTL-type circuit is operated, the input terminal and output terminal of the second logic gate circuit being respectively an input terminal (IN) and an output terminal of the input stage (Si).

2. An interface circuit according to Claim 1, characterized in that the first logic gate circuit (M2,N3) is an inverter circuit.

3. An interface circuit according to any of Claims 1 and 2, characterized in that the second logic gate circuit (M5,M6) is an inverter circuit.

4. An interface circuit according to any of Claims 1 and 2, characterized in that the second logic gate circuit is a trigger circuit.

5. An interface circuit according to any of Claims 2 and 3, characterized in that said inverter circuit comprises a pair of complementary transistors having control terminals connected together to form the input terminal of said inverter circuit and first terminals connected together to form the output terminal of said inverter circuit.

6. An interface circuit according to Claim 5, characterized in that the complementary transistors of said inverter circuit are connected, via second terminals, between one leg of the current mirror circuit (M1,M4) and the first terminal of the supply voltage generator.

7. An interface circuit acccording to any of Claims 1, 2, 3, 4, 5 and 6, characterized in that the current mirror circuit comprises first (M1) and second (M4) transistors, each having first and second terminals whereby they form one leg of said current mirror circuit and a control terminal, the control terminals of said first and second transistors being connected together to form the control terminal (A) of the current mirror circuit.

8. An interface circuit according to any of the preceding claims, characterized in that the logic gate circuits are inverter circuits.

9. An interface circuit according to any of the preceding claims, characterized in that it is integrated monolithically using a technology of the CMOS type.

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | PATENT ABSTRACTS OF JAPAN vol. 12, no. 115 (E-599) (2962) 12 April 1988 & JP-A-62 243 422 (NIPPON TEXAS INSTR K. K.) 23 October 1987 * abstract * *see especially figure 3c of the published application* | 1-3,5-9 | H03K19/003 H03K19/0185 |
| X | US-A-4 563 595 (B. K. BOSE) * abstract; figure 1 * | 1,2,4-8 | |
| A | PATENT ABSTRACTS OF JAPAN vol. 12, no. 124 (E-601) (2971) 16 April 1988 & JP-A-62 248 308 (SEIKO EPSON CORP) 29 October 1987 * abstract * | 1 | |
| A | PATENT ABSTRACTS OF JAPAN vol. 12, no. 111 (E-598) (2958) 8 April 1988 & JP-A-62 242 418 (SEIKO EPSON CORP) 23 October 1987 * abstract * | 1 | TECHNICAL FIELDS SEARCHED (Int.Cl.6) H03K |
| A | US-H-H802 (S. HISANO) * the whole document * | 1 | |
| A | US-A-4 555 642 (L. J. MORALES) * the whole document * | 1 | |
| A | PATENT ABSTRACTS OF JAPAN vol. 9, no. 143 (E-322) (1866) 18 June 1985 & JP-A-60 025 323 (FUJITSU K. K.) 8 February 1985 * abstract * | 1 | |

-/--

The present search report has been drawn up for all claims

| Place of search | Date of completion of the search | Examiner |
|---|---|---|
| BERLIN | 17 May 1994 | Arendt, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................................................
& : member of the same patent family, corresponding document

EPO FORM 1503 03.82 (P04C01)

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | PATENT ABSTRACTS OF JAPAN vol. 12, no. 189 (E-616) (3036) 2 June 1988 & JP-A-62 292 014 (FUJITSU LTD) 18 December 1987 * abstract *<br>--- | 1,4 | |
| A | EP-A-0 251 383 (N. V. PHILIPS' GLOEILAMPENFABRIEKEN) * abstract; figure 2 *<br>----- | 1,4 | |
| | | | TECHNICAL FIELDS SEARCHED (Int.Cl.6) |

The present search report has been drawn up for all claims

| Place of search | Date of completion of the search | Examiner |
|---|---|---|
| BERLIN | 17 May 1994 | Arendt, M |

EPO FORM 1503 03.82 (P04C01)